# EUROPEAN PATENT APPLICATION

(11) **EP 2 664 941 A1**
(43) Date of publication of application: **20.11.2013**
(21) Application number: 12168422.9
(22) Date of filing: 17.05.2012
(51) Int. Cl.: G01R 33/46, G01N 24/08

(54) **Method for deciding whether a sample is consistent with an established production norm for heterogeneous products**

(71) Applicant: Istituto di Ricerche Chimiche e Biochimiche "G. Ronzoni", 20133 Milano (IT); Anglo - Italian Chemometrics Ltd., Southport Merseyside PR8 4JS (GB)
(72) Inventor: Torri, Giangiacomo, 20133 Milano (IT); Guerrini, Marco, 21047 Saronno (IT); Rudd, Timothy Robert, Prenton Merseyside CH43 0RP (GB)
(74) Representative: Serravalle, Marco

(57) **Abstract**

A method of analysis of a heterogeneous product, for example heparin or heparin derivatives, to define whether said heterogeneous product is consistent with a library of verified heterogeneous samples (Library 1) by analysing the variation, natural or alien.

The acceptable variation of the heterogeneous product is determined by comparing Library 1 with a second set of verified spectra (Library 2), by use of comparative two-dimensional correlation spectroscopic filtering (comparative 2D-COS-f).

The method comprises obtaining a one-dimensional complex spectrum, for example ¹H-NMR spectra, of a heterogeneous product and testing if it has features that are greater than features found testing a spectrum from Library 2 against Library 1.

In a second embodiment comparative 2D-COS-f with iterative random sampling (2D-COS-firs) is applied, which provides a more accurate and stable extraction of aliens/unnatural features.

The method defines whether a test sample is consistent with a library of production norms of heterogeneous products; determines the acceptance criteria to be considered as normal production for heterogeneous products and detects species alien to the production norms of heterogeneous products.

## Description

### Background of the invention

. Many areas of industrial production, including pharmaceutical production and food production, have to deal with structurally heterogeneous products, which are anyhow regarded as one type of material. The property of a material of having a range of structures (heterogeneity) is an issue in industrial production because of the difficulty of monitoring the precise nature of the material.

. In a molecule this heterogeneity can take several forms: it can comprise a range of different molecular weights in the case of a homopolymer (e.g. cellulose), varied sequence with the same molecular formula, varied sequence and molecular weight, as well as, in some cases, different degrees or types of substitution or branching.

. Typically, the spread of structures can only be monitored overall. This is usually performed by using one or several physical techniques, which must be sensitive to one or more of the variable properties. These techniques measure the molecular weight or size, and report the average of this property for the material under examination.

. However in many industrial processes, the ability to monitor the composition in more detail, for example to provide sequence information or the means of setting acceptance criteria for a particular measure of quality control, would be highly desirable.

. A typical example of heterogeneous product, related to the pharmaceutical industry, is the widely used anticoagulant agent heparin, which is a linear polysaccharide comprising a mixture of polysaccharide chains with both varied sequences and a spread of molecular weights. Moreover, since it is a natural product extracted from animal mucosa (at present) it is also subjected to variation due to individual animal, regional variation and even seasonal differences. Furthermore, it can have additional structural modifications, which are introduced during the extraction and processing procedures. Heparin consists of 1,4 linked uronate-glucosamine unit: the uronate residue is primarily α-L-iduronic acid (α-L-IdoA), but can also be the C-5 epimer β-D-glucuronic acid (β-D-GIcA). The uronic acid can be O-sulfated at position 2, while the α-D-glucosamine (α-D-GIcN) residue can be O-sulfated at positions 6 and 3, the latter being rarer. Furthermore, the glucosamine can have multiple modifications at position 2, being N-sulfated, N-acetylated or a free amine. The most common disaccharide is the tri-sulfated structure 2-O-sulfated iduronic acid and 6-O-sulfated N-sulfated glucosamine.

. Producers and regulatory authorities share an interest in knowing more about the composition of such materials for several reasons. The first is that it would provide the means by which a better-defined and reproducible product could be produced in the sense of it being more homogeneous. This would also help to provide a reference to which each production run could be compared. Second, more detailed information that can link structure and activity can be provided to the manufacturer. These are of considerable importance in the growing area of biotechnological production, including bio-similar compounds/agents, and generic products in the pharmaceutical industry.

. The achievement of these aims is a considerable challenge as it is required to compare products, each of which consists of mixtures of material and whose compositions cannot be defined precisely owing to the difficulties of separation, identification and/or quantification of the components.

. Several NMR analytical techniques have been developed in order to analyse heterogeneous molecules.

. One is principal component analysis (PCA), which decomposes a matrix of numerical data into a number of model features that, when recombined will reproduce closely the original dataset. This can be used to examine how different heterogeneous samples are related to each other, but lacks information on the alien features that can be present in a sample when compared to another.

. Another is two-dimensional correlation spectroscopy (2D-COS) which is a means of elucidating correlated and uncorrelated changes in perturbed chemical systems, this perturbation maybe be mechanical or chemical. 2D-COS analysis can be performed on data generated by different forms of spectroscopy; it can be performed on a single dataset, as a perturbed chemical system observed by one form of spectroscopy (homo-correlations), or between spectroscopic data generated by two different forms of spectroscopy for the same system and then correlated together (hetero-correlations).

. A development of 2D-COS is two-dimensional correlation spectroscopic filtering (2D-COSf). In 2D-COSf the spectrum of a heterogeneous sample is tested against a library of spectra of verified heterogeneous products (Library 1). Library 1 is used to "filter" the test sample spectrum, removing spectral features consistent with verified heterogeneous products library and leaving only alien features, if present. Any feature that remains is considered not to be consistent with the Library 1 of verified heterogeneous compounds. However 2D-COSf does not give information on whether the extracted alien features arise from variations due to natural heterogeneity or from unnatural signals. Indeed since in a heterogeneous polymer no two samples are identical, it is conceivable that, if a *bona fide* heterogeneous test sample is analysed using 2D-COS-f against a library containing *bona fide* heterogeneous samples, spurious signals may be found. Thus a pass or fail criteria needs to be set that handles the natural variation within heterogeneous samples.

. Therefore the need remains for a method of analysis of heterogeneous samples that is generally applicable and capable of providing objective test for assessing the conformity of heterogeneous samples to set standards of production.

### Brief description of the invention

. The present invention provides a method of analysis of heterogeneous products, for example heparin, that can define whether said heterogeneous product is consistent with a library of verified heterogeneous samples by analysing the variation, whether natural or alien, within a set of heterogeneous samples.

. In 2D-COSf the spectrum of a heterogeneous product is filtered against a library of spectra of verified heterogeneous products (Library 1) and any feature that is not consistent with Library 1 is considered as alien feature.

. The method of the present invention is a new development of 2D-COSf, which makes use of a second set of verified spectra (Library 2) to determine the acceptable variation of the heterogeneous product. Said method is defined "comparative 2D-COS-f" since it compares a filtered test sample with a filtered *bona fide* heterogeneous samples library.

. In one embodiment the method comprises obtaining one-dimensional complex spectra, for example ¹H-NMR spectra, of a heterogeneous product and applying comparative 2D-COS-f. If a heterogeneous product tested against Library 1 has features that are greater than features found testing a spectrum from Library 2 against Library 1 the features are considered not to be consistent with those of Library 1.

. In a second embodiment the method comprises obtaining one-dimensional complex spectra, for example ¹H-NMR spectra, of a heterogeneous product and applying comparative 2D-COS-f with iterative random sampling (2D-COS-firs). Each component is tested against the others randomly, where a proportion of Library 1 is randomly selected and a randomly selected spectrum from Library 2 is used in each iteration, while the test sample remains constant. This embodiment provides a measure of the variation within the verified products spectra, to which the test sample can be compared. Iteration with random sampling process provides a more accurate and stable extraction of aliens/unnatural features.

. In another embodiment of the invention, the output of any of comparative 2D-COS-f or 2D-COS-firs, can be used in further statistical tests, for example, principal component analysis, partial least squares or support vector machines, to identify common/known and alien features within the test sample.

. Optionally the content of Library 1 and the content of Library 2 can be tested using principal component analysis in order to verify that they are consistent with each other.

. In the present specifications, spectrum/spectra is/are defined as any complex one-dimensional datum/dataset.

. Through the different embodiments of the invention it is possible to decide whether a test sample is consistent with a library of production norms of heterogeneous products, to determine the acceptance criteria to be considered as normal production for heterogeneous products and to detect species alien to the production norms of heterogeneous products.

### Description of Figures

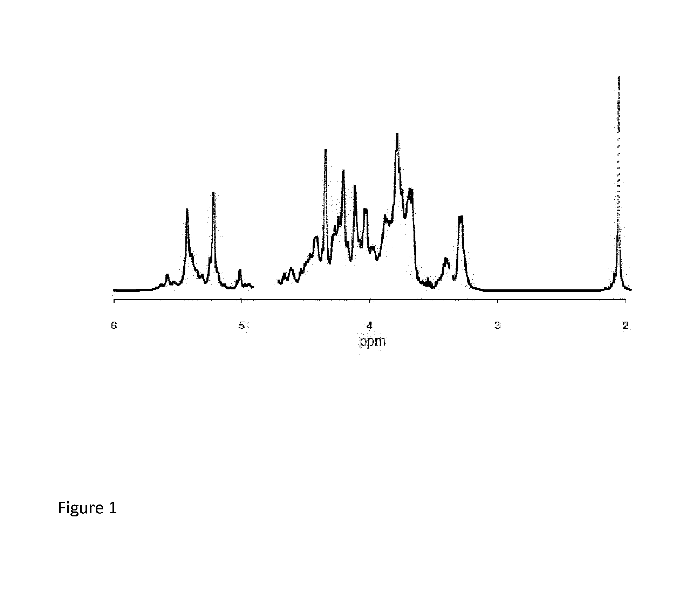

. Figure 1: ¹H NMR spectrum of porcine intestinal mucosal heparin, within the region of 1.95 - 6.00 ppm, the water peak has been cut - 4.90-4.75 ppm.

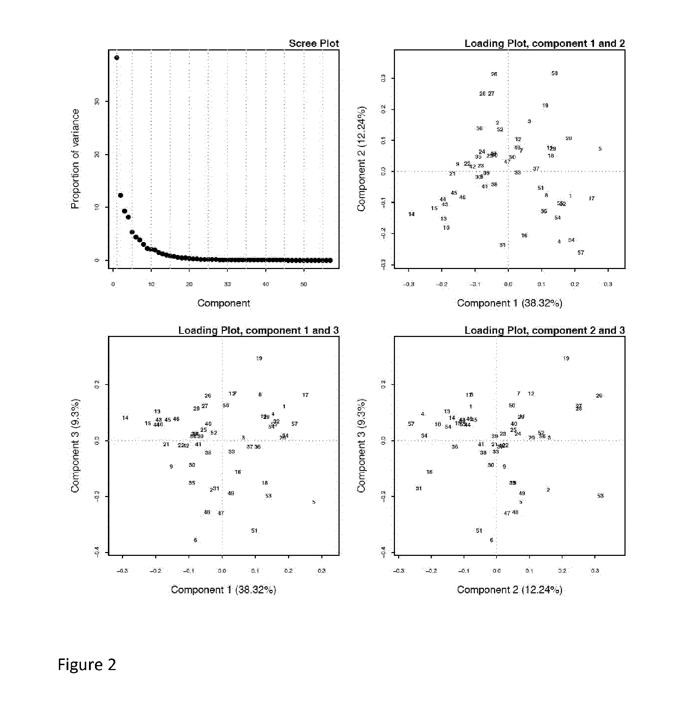

. Figure 2: Principal component analysis of a library of *bona fide* heparin ¹H NMR spectra. Top left: Scree plot, the measure of the variation within the data set. Top right, bottom right and left: sequential loading plots of component one, two and three. The loadings are the proportion of each 'ideal' spectrum contained within a sample actual spectrum, as determined by principal component analysis.

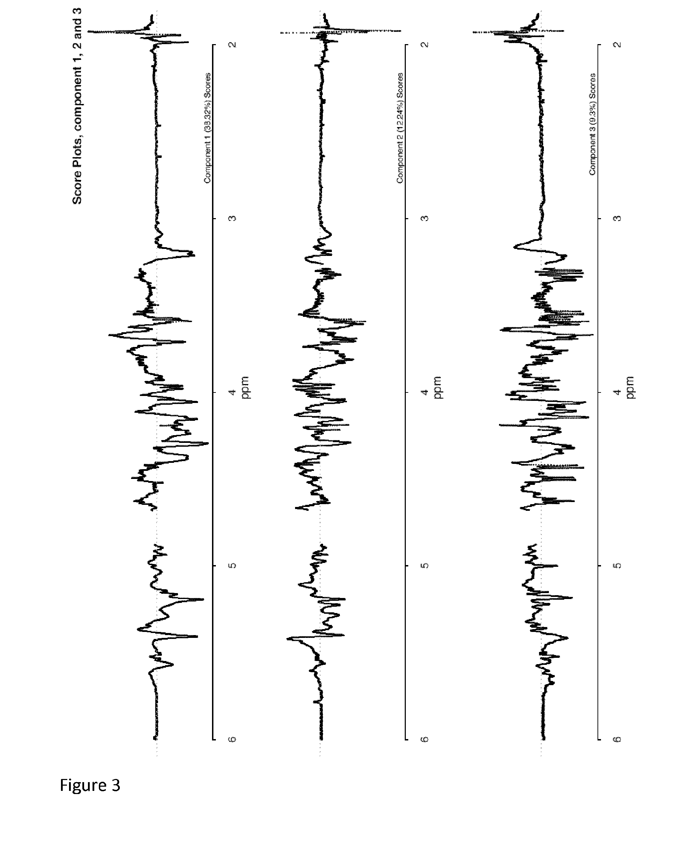

. Figure 3: Principal component analysis of a library of *bona fide* heparin ¹H NMR spectra. Score plots for component one, two and three. The ideal features extracted by principal component analysis.

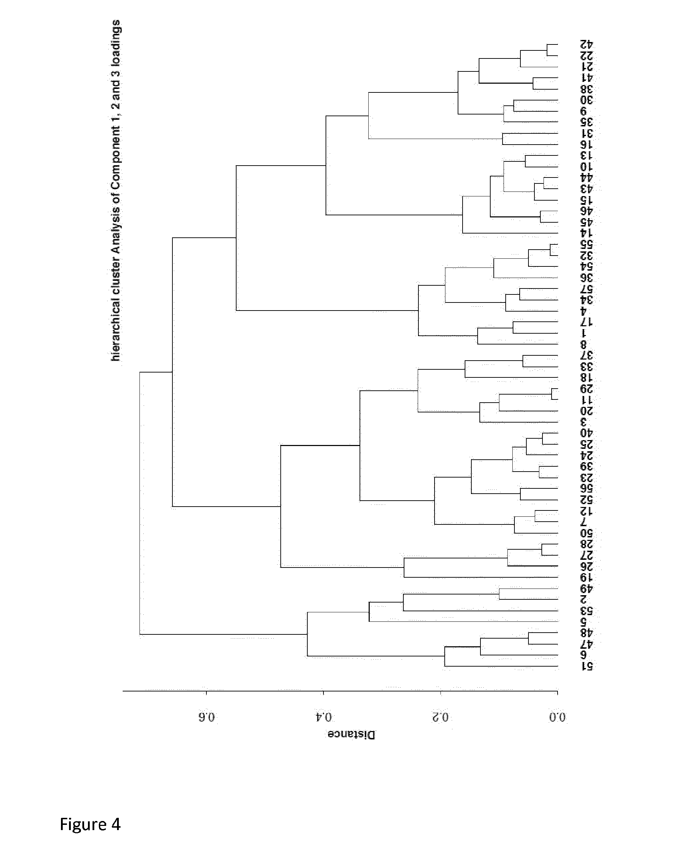

. Figure 4: Principal component analysis of a library of *bona fide* heparin ¹H NMR spectra. Hierarchical cluster analysis of the distance matrix of the loadings for component one, two and three.

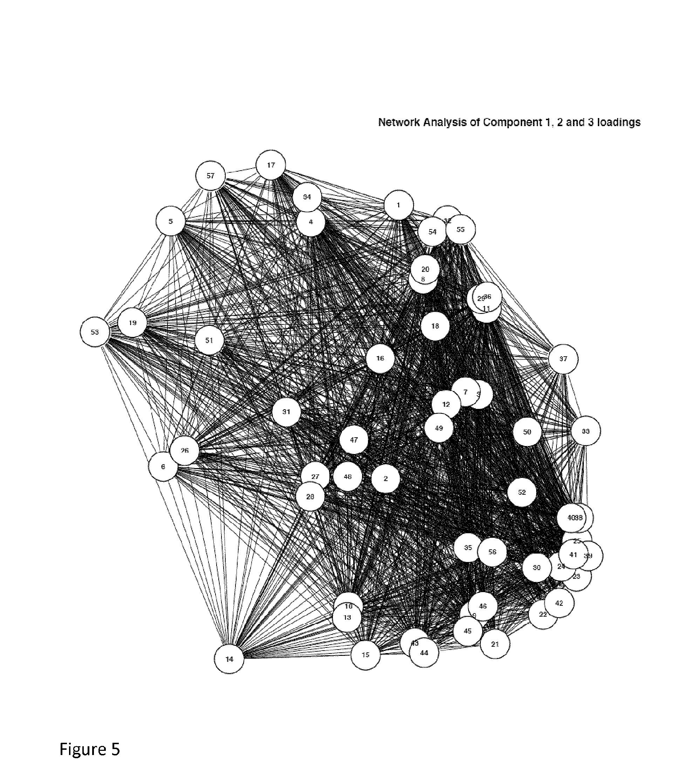

. Figure 5: Principal component analysis of a library of *bona fide* heparin ¹H NMR spectra. Network analysis of the distance matrix of the loadings for component one, two and three.

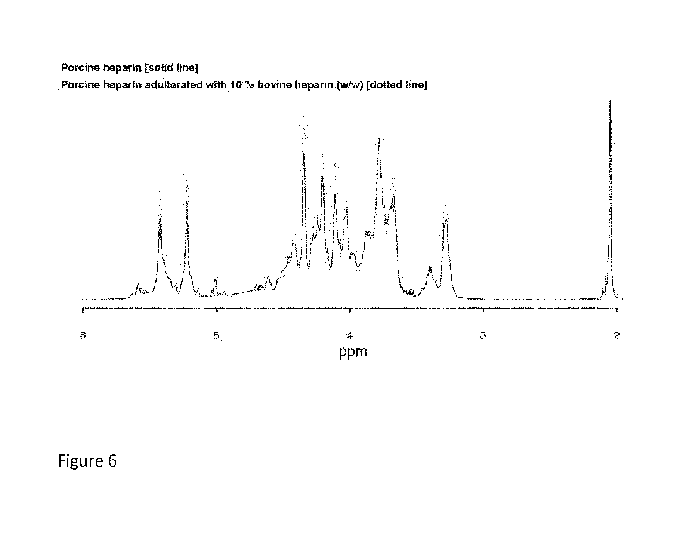

. Figure 6. ¹H NMR spectrum of porcine intestinal mucosal heparin (solid line) and a porcine intestinal heparin adulterated with 10% (w/w) bovine intestinal mucosal heparin (dotted line), within the region of 1.95 - 6.00 ppm, the water peak has been cut - 4.90-4.75 ppm. Note that the two spectra are indistinguishable.

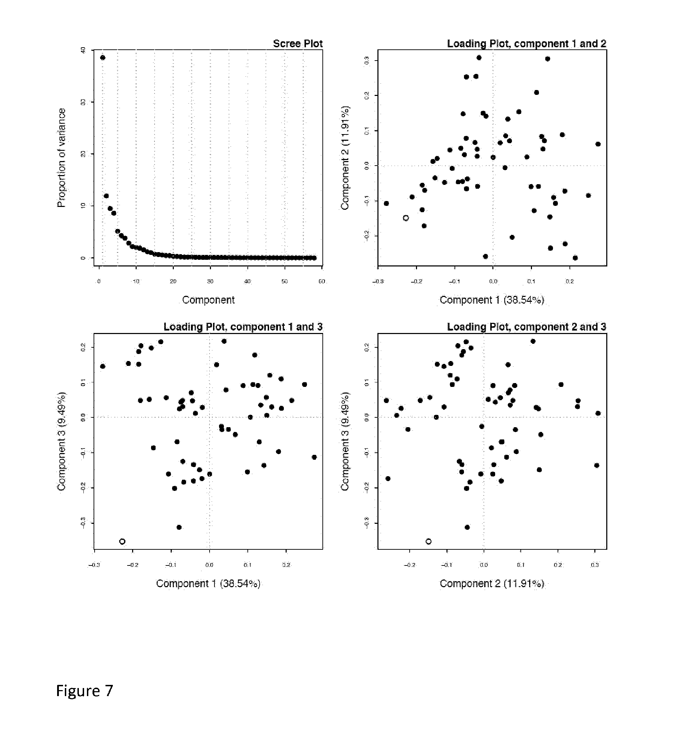

. Figure 7. Principal component analysis of a library of *bona fide* porcine intestinal heparin ¹H NMR spectra containing one sample adulterated with 10% (w/w) bovine intestinal mucosal heparin. Top left: Scree plot, the measure of the variation within the data set. Top right, bottom right and left: sequential loading plots of component one, two and three. The loadings are the proportion of each 'ideal' spectrum contained within a spectrum of a spectrum, as determined by principal component analysis. Note that the contaminated sample (open circle) is not clearly distinguishable from the *bona fide* porcine intestinal heparin.

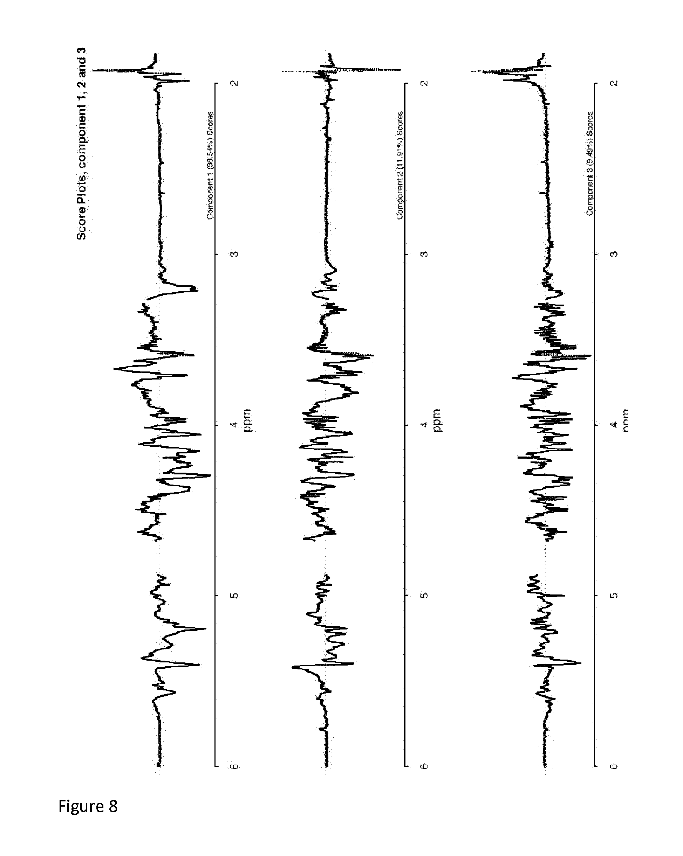

. Figure 8. Principal component analysis of a library of *bona fide* heparin ¹H NMR spectra containing one sample adulterated with 10% (w/w) bovine intestinal mucosal heparin. Score plots for component one, two and three. The ideal features extracted by principal component analysis.

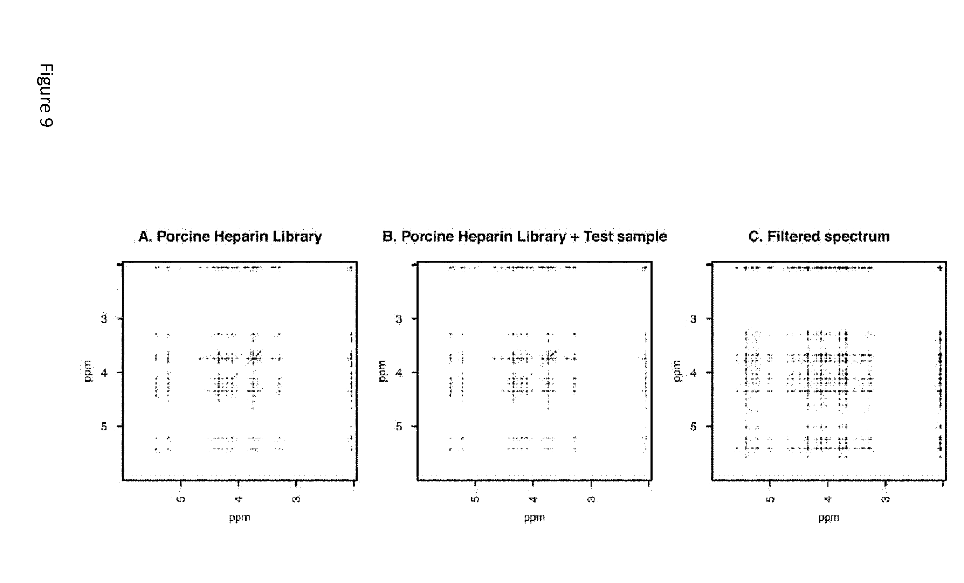

. Figure 9. 2D-COS-f analysis of a heparin sample adulterated with 10% (w/w) bovine intestinal mucosal heparin tested against a library of *bona fide* porcine intestinal heparin. A) covariance matrix of Library 1, the library of bona fide porcine intestinal heparin. B) covariance matrix of Library 1 plus the adulterated test sample. C) difference of B and A. The matrix in panel C contains the features that are not consistent with the spectral features contained within Library 1, i.e., the alien bovine heparin signals.

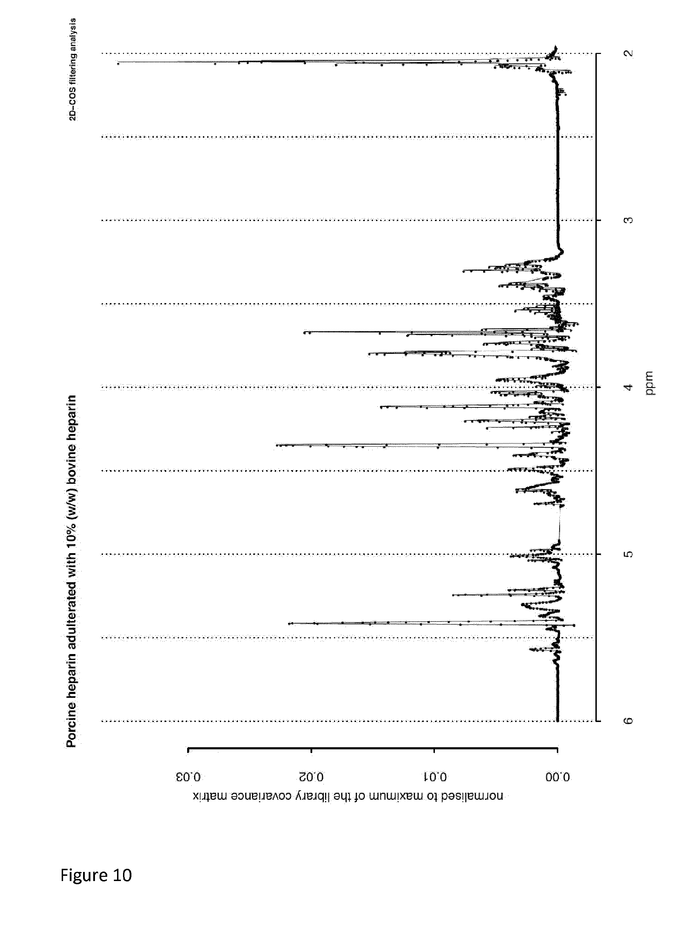

. Figure 10. The diagonal of Figure 9 panel C, The power spectrum contains features of the alien bovine heparin (positive correlations [features above the x axis] and negative correlations [features below the x axis] dotted line). The diagonal is the variance of the covariance matrix. The amplitude is normalised to the maximum value of the covariance matrix of Library 1.

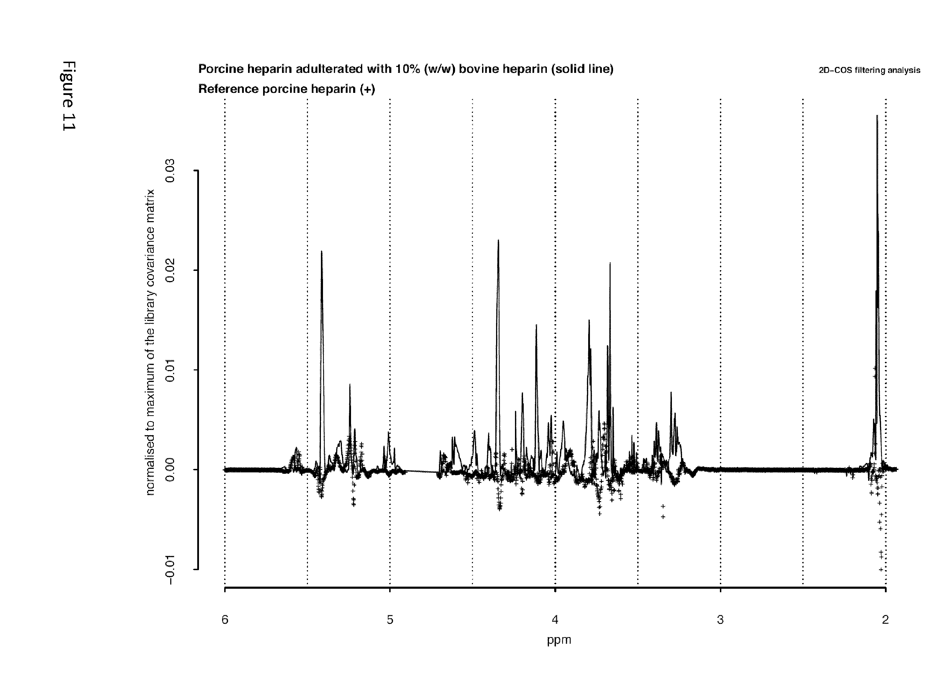

. Figure 11. 2D-COS-f analysis of a porcine intestinal mucosal heparin sample adulterated with 10% (w/w) bovine intestinal mucosal heparin tested against a library of *bona fide* porcine intestinal heparin (black line, positive correlations [features above the x axis] and negative correlations [features below the x axis]). In this circumstance as well as the test sample being tested against Library 1, the definition of the heterogeneous sample, a *bona fide* heparin not contained within Library 1 is also tested against the library (+ symbol). This second test illustrates the acceptable variation of the heterogeneous product in question. If the amplitude of the filtered spectrum of the test sequence is greater than this, it is considered to contain alien or non-consistent features.

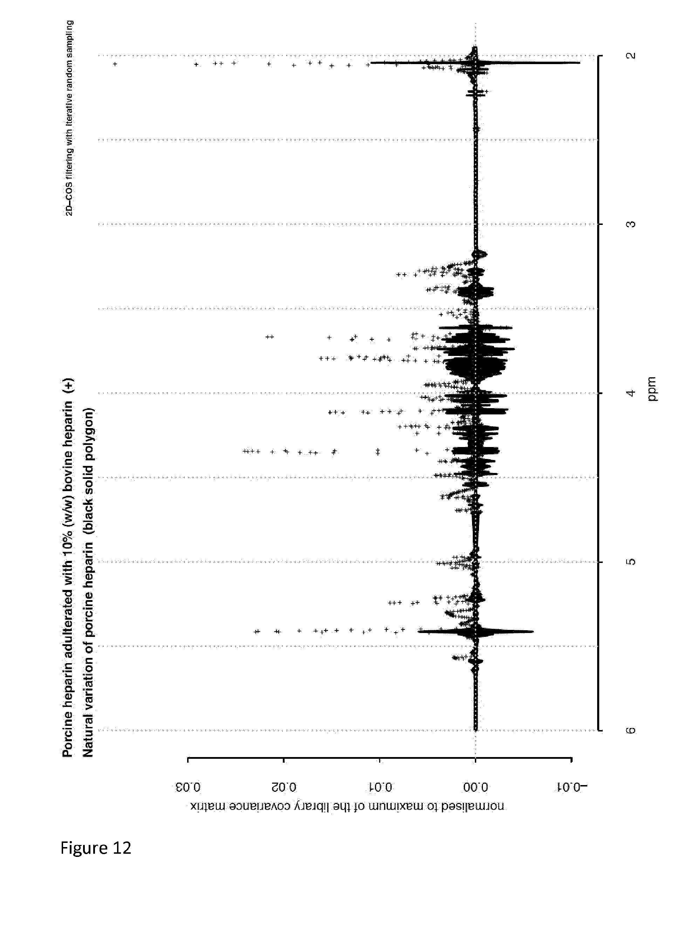

. Figure 12. 2D-COS-f analysis of a porcine intestinal mucosal heparin sample adulterated with 10% (w/w) bovine intestinal mucosal heparin tested against a library of *bona fide* porcine intestinal heparin (+ symbol). In this circumstance as well as the test sample being tested against Library 1, the definition of the heterogeneous sample, a second set of *bona fide* heparin, Library 2, not contained within Library 1 is also tested against Library 1 (black polygon). This second test illustrates the acceptable variation of the heterogeneous product in question. If the amplitude of filtered spectrum of the test sample is greater than this, then it is considered to contain alien or non-consistent features. The black polygon is the pass/fail criteria for the sample being a verified heterogeneous sample. In this circumstance the black dotted line is the modulus of the 95% confidence interval (|x±SEₓ × 1.96|) for 1500 iterations of random sampling.

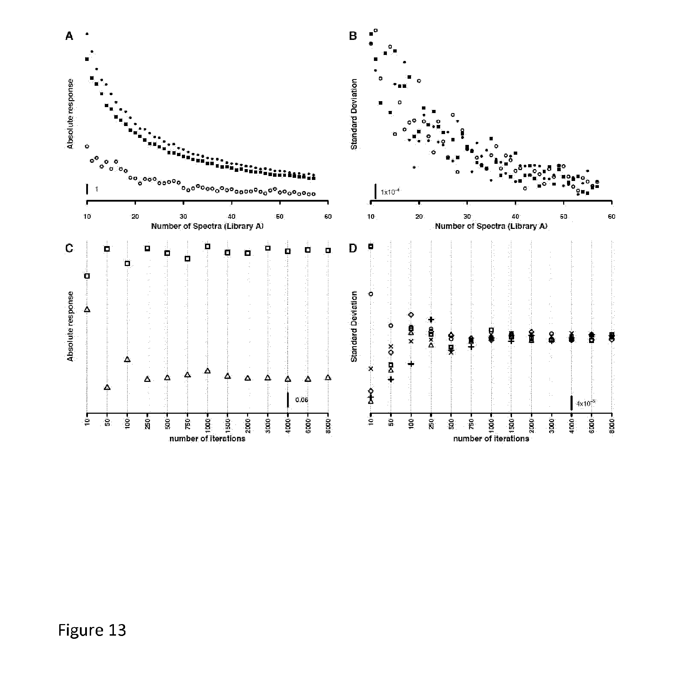

. Figure 13. The effect of Library 1 size on 2D-COS-firs. The size of Library 1, that defines the heterogeneous polymer, varied from 10 to 57 spectra, with a step size of 1. At each step a test sample (heparin contaminated with 1% bovine mucosal or ovine mucosal heparin) was filtered with 100 iterations, with the mean spectrum and the standard deviation at each point along the spectrum being recorded. A) The absolute response (area under the modulus of the power spectrum) at each step is plotted; open circles: randomly filtered spectrum from Library 2 (pass or fail criteria); black square: heparin contaminated with 1% ovine mucosal heparin; black circle: heparin contaminated with 1% bovine heparin. B) Standard deviation at a randomly chosen point [3.03 ppm]. C) The absolute response (area under the modulus of the power spectrum) plotted against number of iterations for 2D-COS-firs of porcine intestinal mucosal heparin contaminated with 5% (small contamination) [open triangle] and 20% (gross contamination) [open square] bovine mucosal heparin. D) Standard deviation at a randomly chosen point [3.03 ppm] for the filtered spectra of heparin adulterated with 30% to 1% bovine heparin.

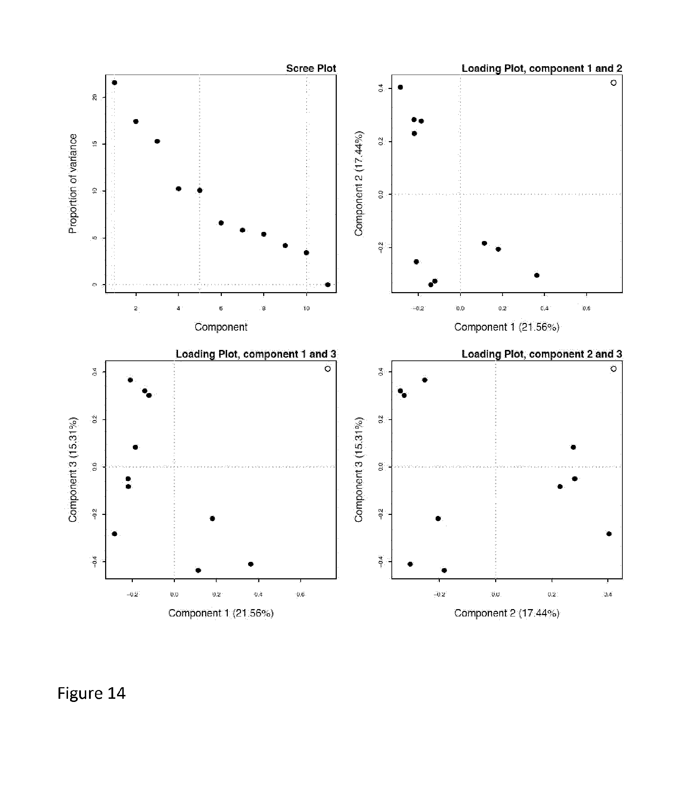

. Figure 14. Principal component analysis of one porcine intestinal mucosal heparin sample that has been contaminated with 1% (w/w) bovine mucosal heparin and with ten porcine intestinal mucosal heparin samples. In this circumstance all the samples spectra have been filtered by Library 1, the definition of porcine intestinal mucosal heparin, this removes all signs from the spectra that are consistent with features contained with Library 1. In Figure 7 it is difficult to differentiate a heparin sample contaminated with 10% (w/w) bovine intestinal mucosal heparin, where as after filtering using 2D-COS-firs it is possible to differentiate a sample contaminated with a much lower amount material.

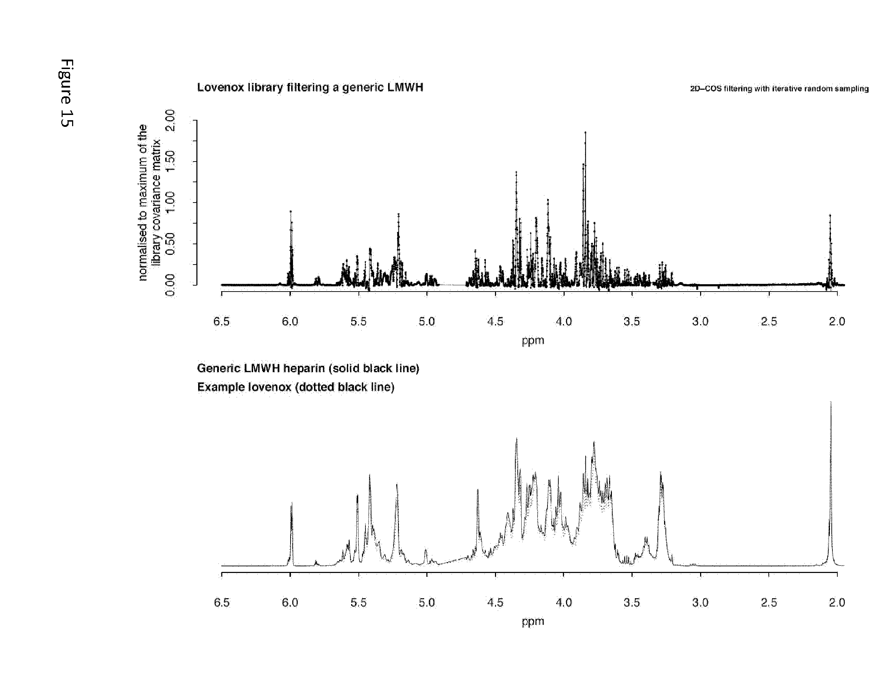

. Figure 15. 2D-COS-firs of a generic LMWH, with Library 1 now containing lovenox LMWH. Here 2D-COS-firs is used to illustrate the features within the generic LMWH that are not common with lovenox samples contained with Library 1. In the upper panel the filtered result, in the lower panel the test sample spectrum and an example spectrum of lovenox.

### Detailed description of the invention

. The present invention provides a method of analysis of heterogeneous products capable of defining whether a heterogeneous product, for example a natural or bio-manufactured product, is consistent with a library of verified heterogeneous samples by analysing the variation, whether natural or alien, within a set of heterogeneous samples.

. Preferably the heterogeneous product is heparin, high-, low- and ultra-low- molecular weight.

. In a first embodiment a one-dimensional complex spectrum of the product to be tested (Test sample), for example ¹H-NMR spectrum, is obtained and it is tested against a library of verified heterogeneous products (Library 1) by use of comparative 2D-COS-f as described hereafter.

. Before testing the heterogeneous product against Library 1 by use of comparative 2D-COS-f, a second library of verified products (Library 2) is tested against Library 1 by use of comparative 2D-COS-f in order to determine the acceptable variation within Library 1. Both Libraries 1 and 2 comprise *bona fide* samples of the heterogeneous product.

. A suitable Library 1 contains more than 2 spectra, preferably more than 50 spectra.

. Library 1 contains a number of spectra greater than the number of spectra of Library 2.

. The contents of Library 1, that defines the features of the heterogeneous product, and the contents of Library 2, that measures the acceptable variation of the heterogeneous product, comply with the requisite regulations. The consistency of the members of Library 2 with Library 1 can also be confirmed using an explorative statistical technique such as principal component analysis.

. Library 1 is mean centred by subtracting the mean spectra of Library 1 from each of the spectra in Library 1 (*i*) and a mean-centred data set x is obtained; the covariance matrix of the mean-centred Library 1 (COV_{LIB}) is then determined (*ii*), where COV_{LIB} is equal to the outer product matrix of x, scaled to the number of spectra n in the dataset (COV_{LIB}=1/(n-1)*xx^{T}); steps (*i*) and (*ii*) are then repeated on Library 1 plus one of the spectra from Library 2 and the covariance matrix COV_{LIBTEST} is obtained (*iii)*; COV_{LIB} is subtracted from COV_{LIBTEST} *(iv)* obtaining the difference covariance matrix ΔCOV_{LIBTEST-LIB} (COV_{LIBTEST}- COV_{LIB}=ΔCOV_{LIBTEST-LIB}).

. ΔCOV_{LIBTEST-LIB} is a measure of the acceptable variation within the heterogeneous samples.

. The same procedure (*iii-iv*) is repeated one by one for all the spectra that are within Library 2 *(v)*: the difference covariance spectra form the acceptance criteria whether the Test sample conforms to the library or not.

. Steps (*i*) and (*ii*) are then repeated on Library 1 plus the spectrum of the heterogeneous product to be tested (Test sample) obtaining the covariance matrix COV_{TEST} (*vi).* COV_{LIB} is then subtracted from COV_{TEST} (*vii)* forming the difference covariance matrix ΔCOV_{TEST-LIB} (COV_{TEST}-COV_{LIB}=ΔCOV_{TEST-LIB}) revealing the features of the Test sample that are not consistent with Library 1.

. The following pass-fail criteria is applied in the analysis of the Test sample: if the amplitude of any of the features within ΔCOV_{TEST-LIB} is greater than any of the features within ΔCOV_{LIBTEST-LIB}, then the Test sample fails the test (see scheme 1).

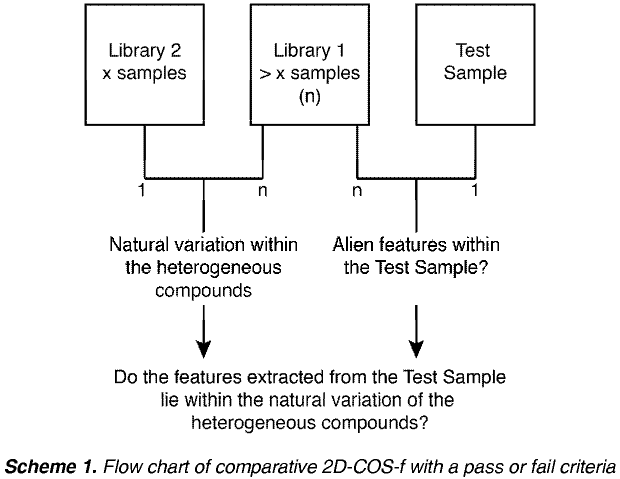

. In a second embodiment two-dimensional correlation spectroscopy filtering with iterative random sampling (2D-COS-firs) is applied.

. 2D-COS-firs provides more accurate measure of the variation within the verified spectra (Library 2 against Library 1) and more accurate extraction of alien/unnatural features from the spectrum of the test sample by using a randomly selected proportion of Library 1 with one randomly selected spectrum from Library 2 and iterating the procedure while the test sample remains constant.

. In this second embodiment ΔCOV_{LIBTEST-LIB} is determined for a randomly selected proportion of Library 1 and one randomly selected spectrum of Library 2 with the steps (*i-iv*) described for the first embodiment; these steps are repeated *j* times until the response is stable, where *j* is greater than 10, preferably *j* is from 10 to 8000, more preferably from 1000 to 2000. The mean is determined for the *j* filtered spectra and a measure of the variation is determined at each point along the spectra, for example 95% confidence interval at each point (the mean value at a point ± the error of the mean at that point x 1.96). This forms the acceptance criteria whether the test spectrum conforms to the library or not (see scheme 2).

. The covariance matrix COV_{TEST} of the same randomly selected portion of Library 1 plus the test spectrum and the ΔCOV_{TEST-LIB} are determined as in the first embodiment (steps *vi and vii*); these steps are repeated *j* times, until the response is stable, where *j* is greater than 10, preferably *j* is from 10 to 8000, more preferably from 1000 to 2000, determining the mean spectrum of the *j* repeats.

. If the alien variation within the test sample (i.e. the amplitude of the spectrum determined by testing the test sample spectrum against Library 1) is greater that the natural variation of the library measured at each point of the spectra (i.e., the 95% confidence interval at each point), then the test sample is considered not to be consistent with the definition of the heterogeneous samples, Library 1.

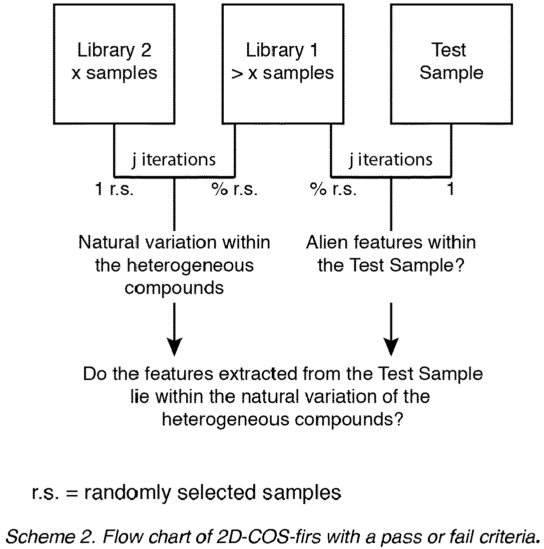

. To perform the principal component analysis the spectra are mean-centred; the covariance matrix of the mean centred set of spectra x is determined (c=xx^{T}, where c is equal to the cross product matrix of x); the Eigen decomposition/diagonalization of the covariance matrix is performed, which forms a new orthonormal coordinate system, the results of which is c=TΛT^{T}, where Λ is a diagonal matrix of eigenvalues while T are the eigenvectors (loadings). The data set x are then projected on to the new coordinate system by the following transformation S=xT, where T are the eigenvectors and S are the component scores.

. In another embodiment of the invention, the output of any of comparative 2D-COS-f or 2D-COS-firs, can be used in further statistical tests, for example, principal component analysis, partial least squares or support vector machines, to identify common/known and alien features within the test sample.

### Examples

. **Comparative example 1: Principal Component Analysis (PCA) of porcine intestinal heparin spectrum**. ¹H NMR spectrum of porcine intestinal mucosal heparin is obtained. Porcine intestinal mucosal heparin is a heterogeneous carbohydrate, therefore its ¹H NMR spectrum contains many overlapping bands (Figure 1). In Figure 2 a library of 57 *bona fide* pharmaceutical porcine intestinal mucosal heparins are differentiated. These 57 spectra can be considered as a definition of the heterogeneous polymer heparin. Principal component analysis decomposes the spectra into ideal spectra (components) that can be linearly summed to obtain any spectra within the test dataset. The scree plot within Figure 2 indicates the importance of the derived components: in this case there is one major component. The loading plots in Figure 2 illustrate how the test spectra are composed of different amounts of the PCA derived components. The spectral features of each component are shown in the score plots (Figure 3).

. **Comparative example 2: Method to detect ruminant material contaminants in porcine heparin.** Principal component analysis can be used to find oddities within a dataset.
Figure 6 contains the ¹H NMR spectra of *bona fide* pharmaceutical porcine intestinal mucosal heparin and a heparin sample contaminated with 10% bovine mucosal heparin (w/w). Visually it is difficult to differentiate the two (Figure 6). Figure 7 and 8 contain the results of PCA of the 57 spectra, which are considered in this circumstance to constitute the definition of pharmaceutical porcine intestinal mucosal heparin, with the contaminated heparin sample, containing 10% (w/w) bovine intestinal mucosal heparin. As can be seen from this analysis, the contaminated sample isn't clearly differentiated from the definition of pharmaceutical porcine intestinal mucosal heparin.

. **Comparative example 3: 2D-COSf analysis of a heparin sample adulterated with 10% (w/w) bovine intestinal mucosal heparin**. Instead of trying to decompose the entire dataset, test sample and *bona fide* pharmaceutical porcine intestinal mucosal heparin samples, into components, the 57 heparin spectra, which are considered to be an example of the definition of pharmaceutical porcine intestinal mucosal heparin, can be used to "*filter*" the test sample removing spectral features consistent with *bona fide* pharmaceutical porcine intestinal mucosal heparin leaving only alien features, when present. Figure 9 illustrates the process of 2D-COS-f: Figure 9A contains the covariance matrix formed from the 57 ¹H NMR spectra which comprise an example definition of pharmaceutical porcine intestinal mucosal heparin; this is a pseudo-TOCSY spectra where features that change together within the dataset are linked together. The spectrum of the test sample is added to the 57 spectra and the covariance matrix is formed again. To filter the porcine intestinal mucosal heparin features from the test spectrum the covariance matrix represented in Figure 9A is subtracted from the covariance matrix represented in Figure 9B; this leaves the difference covariance matrix (Figure 9C) which contains the alien features present in the test sample, i.e. the features due to the bovine heparin contaminant in this circumstance. The diagonal of the difference covariance matrix (Figure 9C) is shown in Figure 10: the spectrum contains alien features attributed to bovine heparin, specifically the anomeric region which is due to the presence of a higher amount of de-6-O-sulfation within bovine mucosal heparin.

. **Example 1: Analysis of a porcine intestinal mucosal heparin sample adulterated with 10% (w/w) bovine intestinal mucosal heparin by comparative 2D-COSf.** According to the first embodiment of the invention, a test sample is tested (filtered) against Library 1 of *bona fide* porcine intestinal mucosal heparin, which defines the heterogeneous sample. A *bona fide* heparin, contained in a second library (Library 2) and not contained within Library 1, is also tested (filtered) against Library 1. This second test illustrates the acceptable variation of the heterogeneous product in question. The test sample filtering by Library 1 is then compared with the *bona fide* porcine intestinal mucosal heparin sample of Library 2, filtered by the Library 1 as well. If the amplitude of the filtered spectrum of the test sample is greater than the amplitude of the filtered spectrum of the Library 2 filtered *bona fide* heparin, it is considered to contain features alien or non-consistent to porcine intestinal mucosal heparin. In this example the porcine intestinal mucosal heparin contaminated with 10% (w/w) bovine mucosal heparin failed the test.

. **Example 2: Analysis of a porcine intestinal mucosal heparin sample adulterated with 10% (w/w) bovine intestinal mucosal heparin by iterative random sampling (2D-COS-firs).** According to the second embodiment of the invention, random sampling is used to provide a stricter pass or fail criteria. This analysis requires three data sets: a library of *bona fide* porcine intestinal mucosal heparin which is consider to be the definition of porcine intestinal mucosal heparin (Library 1 - containing 57 spectra in this example), a further library of *bona fide* porcine intestinal mucosal heparin which is a test library which will determine the natural variation within porcine intestinal mucosal heparin (Library 2 - containing 12 spectra in this example) and finally the test sample. The pass or fail criteria is found by filtering a randomly selected sample from Library 2 by a random selection of Library 1 (the number of samples contained within Library 1 - 1), this is repeated 1500 times and the resultant spectra can be averaged to form a spectrum which encompassed the average natural variation with heparin. Here we determined the 95% confidence interval (x±SEₓ × 1.96) and used it as the pass or fail criteria (Figure 12). Then the actual test sample went through a similar process, being filtered by a random selection of Library 1 (the number of samples contained within Library 1 - 1) iterating this for 1500 times: the results are averaged and compared against the measure of natural variation - the pass or fail criteria. If any signal lays outside the measure of natural variation - the pass or fail criteria - then it is considered to be alien to the porcine intestinal mucosal heparin and that the sample contains non-porcine intestinal mucosal heparin material. In the example shown here the porcine intestinal mucosal heparin contaminated with 10% (w/w) bovine mucosal heparin fail the test.

**Example 3: The effect of Library 1 size on the analysis of heparin contaminated with 1% bovine mucosal or ovine mucosal heparin by 2D-COS-firs**. The effect of varying the size of Library 1 and the number of iterations used for 2D-COS-firs is illustrated in Figure 13. When the sample is iterated 1500 the standard deviation at any point of the spectrum becomes stable and no improvement occurs if the number of iteration is increased over 1500 times (Figure 13 C and D). While using a Library 1 containing 57 spectra provides sensitive filtering, additional spectra added to Library 1 would improve the result (Figure 13A and B); for a stable result at least 50 spectra are required.

. **Example 4: Principal Component Analysis of one porcine intestinal mucosal heparin contaminated with 1% bovine mucosal heparin after 2D-COS-firs with 10 *bona fide* porcine intestinal mucosal heparin spectra.** In this example principal component analysis is applied after all the samples spectra have been filtered by Library 1, the definition of porcine intestinal mucosal heparin, removing all signs from the spectra that are consistent with features contained with Library 1. As can be seen in Figure 14 the removal of all the features that are consistent with Library 1 improves the separation of the spectra with principal component analysis dramatically. While in comparative example 2 it was difficult to differentiate porcine intestinal mucosal heparin contaminated with 10% (w/w) bovine mucosal heparin, here it is possible to differentiate a sample contaminated with a much lower amount material. Therefore, 2D-COS-firs can be used to improve the sensitivity of other statistical techniques.

. **Example 5: Method to differentiate LMWHs produced by different manufactures.** Here 2D-COS-firs is used to filter a generic LMWH against Library 1 that contains lovenox LMWH spectra (Figure 15). By filtering the generic LMWH test sample against the lovenox-containing Library 1 all the features within the generic LMWH that are not consistent with lovenox are revealed.
Publications:
Noda, I. Two-dimensional infrared-spectroscopy. Journal of the American Chemical Society, 1989; 111(21), 8116-8.
Noda, I. Generalized 2-dimensional correlation method applicable to infrared, Raman, and other types of spectroscopy. Applied Spectroscopy, 1993; 47(9), 1329-36.
Abdulla, H.A.N., et al. Using Two-Dimensional Correlations of (13)C NMR and FTIR To Investigate Changes in the Chemical Composition of Dissolved Organic Matter along an Estuarine Transect. Environmental science & technology, 2010; 44(21), 8044-49.
Rudd T.R., et al. Site-specific interactions of copper(II) ions with heparin revealed with complementary (SRCD, NMR, FTIR and EPR) spectroscopic techniques. Carbohydrate Research, 2008; 343, 2184-2193.
Rodén L, Ananth S, Campbell P, Curenton T, Ekborg G, Manzella S, Pillion D, Meezan E. Heparin - an introduction. In: Lane DA, Bjork, Lindahl U, eds. AQ3. Heparin and Related Polysaccharides. New York: Plenum Press, 1992; 1-20.
Lindahl U, Lidholt K, Spillmann D, Kjellén L. More to "heparin" than anticoagulation. Thromb Res 1994; 75:1-32.
Casu Bin Chemistry and Biology of Heparin and Heparan Sulphate (Garg, H. G., Linhardt, R. J., and Hales, C. A., eds) 2005; pp. 1-28, Elsevier Ltd., Oxford, UK.
Yates EA, Santini F, Guerrini M, Naggi A, Torri G, Casu B. 1H and 13C NMR spectral assignments of the major sequences of twelve systematically modified heparin derivatives. Carbohydr Res. 1996; 294, 15-27.
Bertini S, Bisio A, Torri G, Bensi B, Terbojevich M. Molecular Weight Determination of Heparin and Dermatan
Sulfate by Size Exclusion Chromatography with a Triple Detector Array. Biomacromolecules 2005; 6, 168-173.
Casu B, Guerrini M, Naggi A et al. Characterization of sulfation patterns of beef and pig mucosal heparins by nuclear magnetic resonance spectroscopy. Arzneim Forsch/Drug Res 1996; 46, 472-477.
Warda M, Gouda EM, Toida T, Chi L, Linhardt RJ. Isolation and characterization of raw heparin from dromedary intestine: evaluation of a new source of pharmaceutical heparin. Comp Biochem Physiol C Toxicol Pharmacol. 2003;136, 357-365.
Linhardt RJ, Gunay NS (1999) Production and chemical properties of low molecular weight heparins. Semin Thromb Hemost 1999; 25, 5-16
Mourier PAJ, Guichard OJ, Herman F, Viskov C, Heparin sodium compliance to the new proposed USP monograph: Elucidation of a minor structural modification responsible for a process dependent 2.10ppm NMR signal, J.Pharm.Biomed.Anal. 2011; 54, 337-344.
Beni S, Limtiaco JF, Larive CK. Analysis and characterization of heparin impurities. Anal Bioanal Chem. 2011; 399; 527-539.
Beaudet JM, Weyers A, Solakyildirim K, Yang B, Takieddin M, Mousa S, Zhang F, Linhardt RJ Impact of Autoclave Sterilization on the Activity and Structure of Formulated Heparin. J. Pharm. Sci. 2011; 100, 3396-3404.
Lee SE, Chess EK, Rabinow B, Ray GJ, Szabo CM, Melnick B, Miller RL, Nair LM, Moore EG. NMR of heparin API: investigation of unidentified signals in the USP-specified range of 2.12-3.00 ppm. Anal Bioanal Chem. 2011; 399, 651-662.
Xu Y, Masuko S, Takieddin M, Xu H, Liu R, Jing J, Mousa SA, Linhardt RJ, Liu J. Chemoenzymatic synthesis of homogeneous ultralow molecular weight heparins. Science. 2011; 334, 498-501.
Winter W, Deubner R, Holzgrabe U. Multivariate analysis of nuclear magnetic resonance datacharacterization of critical drug substance quality of gentamicin sulfate. J Pharm Biomed Anal. 2005; 38, 833-839.
Beyer T, Diehl B, Randel G, Humpfer E, Schäfer H, Spraul M, Schollmayer C, Holzgrabe U. Quality assessment of unfractionated heparin using 1H nuclear magnetic resonance spectroscopy. J Pharm Biomed Anal. 2008; 48, 13-19.
Rudd TR, Gaudesi D, Skidmore MA, Ferro M, Guerrini M, Mulloy B, Torri G, Yates EA. Construction and use of a library of bona fide heparins employing 1H NMR and multivariate analysis. Analyst. 2011; 136, 1380-1389.
Ruiz-Calero V, Saurina J, Galceran MT, Hernández-Cassou S, Puignou L. Estimation of the composition of heparin mixtures from various origins using proton nuclear magnetic resonance and multivariate calibration methods. Anal Bioanal Chem. 2002; 373, 259-65.
Alban S, Lühn S, Schiemann S, Beyer T, Norwig J, Schilling C, Rädler O, Wolf B, Matz M, Baumann K, Holzgrabe U. Comparison of established and novel purity tests for the quality control of heparin by means of a set of 177 heparin samples. Anal Bioanal Chem. 2011; 399, 605-620.
Zang Q, Keire DA, Wood RD, Buhse LF, Moore CM, Nasr M, Al-Hakim A, Trehy ML, Welsh WJ. Determination of galactosamine impurities in heparin samples by multivariate regression analysis of their (1)H NMR spectra. Anal Bioanal Chem. 2011; 399, 635-649.
Jolliffe IT, Principal component analysis, Springer, New York, London, 2002.
Sasic S, Muszynskiand A, Ozaki Y, Appl.Spectrosc., 2001; 55,343-349.
Noda I, Dowrey AE, Marcott C, Story GM, Ozaki Y, Appl. Spectrosc., 2000, 54, 236A-248A.
Rudd TR, Gaudesi D, Skidmore MA, Lima AM, Skidmore MA, Mulloy B, Torri G, Nader HB, Guerrini M, Yates EA. High-sensitivity visualisation of contaminants in heparin samples by spectral filtering of 1H NMR spectra Analyst. 2011; 136, 1390-1398.

## Claims

1. Method of analysis of a heterogeneous product comprising:
a) obtaining a one-dimensional, complex spectrum of the heterogeneous product to be tested (Test sample), preferably by ¹H NMR,
b) obtaining a library of spectra of verified heterogeneous products (Library 1),
c) obtaining a second library of spectra of verified heterogeneous products (Library 2), wherein Library 2 contains a number of spectra x and Library 1 contains a number of spectra n, where n>x and n is more than 2, preferably more than 50,
d) comparing said Library 1 against said Library 2 by comparative two-dimensional correlation spectroscopic filtering (comparative 2D-COS-f),
e) comparing said Test spectra against said Library 1 by comparative 2D-COS-f,
f) identifying the features of said Test spectra which are not consistent to Library 1,
wherein the steps to perform comparative 2D-COS-f comprise:
i. mean-centering Library 1 by subtracting the mean spectra of Library 1 from each of the spectra in Library 1, obtaining the mean-centered data set x,
*ii.* determining the covariance matrix of the mean-centered Library 1 (COV_{LIB}), where COV_{LIB} =1/(n-1)*xx^{T},
*iii.* repeating steps *i-ii* with Library 1 plus one of the spectra from Library 2 obtaining the covariance matrix (COV_{LIBTEST}),
iv. subtracting COV_{LIB} from COV_{LIBTEST} obtaining the difference covariance matrix ΔCOV LIBTEST-LIB,
v. repeating steps *iii-iv* for each of the spectra that are within Library 2,
*vi.* repeating steps *i-ii* with Library 1 plus the spectrum of the Test sample obtaining the covariance matrix (COV_{TEST});
*vii.* subtracting COV_{LIB} from COV_{TEST} obtaining the difference covariance matrix ΔCOV_{TEST-LIB}
wherein the Test sample is considered not consistent with the Library 1 of verified heterogeneous products when it has one or more features within ΔCOV_{TEST-LIB} whose amplitude is greater than any of the features within ΔCOV_{LIBTEST-LIB}.

2. The method of claim 1 wherein 2D-COS-f is performed with iterative random sampling (2D-COS-firs), comprising:
performing steps *i-iv* of comparative 2D-COS-f with a randomly selected proportion of Library 1 and one randomly selected spectrum from Library 2;
performing step *vi* of comparative 2D-COS-f with said randomly selected proportion of Library 1 plus the spectrum of the Test sample;
repeating steps *i-vi* of comparative 2D-COS-f a number *j* of times, wherein *j* is from 10 to 8000, preferably from 1000 to 2000;
further comprising determining the mean spectrum of the *j* repeats;
determining a measure of the variation of Library 1 at each point of the spectra, preferably the 95% confidence interval at each point;
and wherein the Test sample is considered not consistent with the Library 1 of verified heterogeneous products when the amplitude of any of the features within ΔCOV_{TEST-LIB} is greater than the measure of the variation of Library 1 at each point of the spectra.

3. Method according to claims 1-2 further comprising:
verifying the consistency of Library 1 and Library 2 by principal component analysis.

4. Method according to claims 1-3 wherein the heterogeneous product is heparin or heparin derivatives.

5. Method according to claims 1-4 wherein the output of any of comparative 2D-COS-f or 2D-COSfirs is further used in at least one statistical test.

6. Method according to claim 5 wherein the statistical test is at least one selected from the group containing principal component analysis, partial least squares, support vector machines.
